# EUROPEAN PATENT APPLICATION

(11) **EP 4 675 657 A1**
(43) Date of publication of application: **07.01.2026**
(21) Application number: 24766340.4
(22) Date of filing: 29.02.2024
(51) Int. Cl.: H01G 4/228

(54) **ELECTRICAL DEVICE, ELECTRICAL DEVICE ASSEMBLY, MOTOR CONTROLLER AND VEHICLE**

(30) Priority: 03.03.2023 CN 202310238890
(71) Applicant: BYD Company Limited, Shenzhen, Guangdong 518118 (CN)
(72) Inventor: LIAN, Yubo, Shenzhen, Guangdong 518118 (CN); LING, Heping, Shenzhen, Guangdong 518118 (CN); TANG, Chengbo, Shenzhen, Guangdong 518118 (CN); HUANG, Dandan, Shenzhen, Guangdong 518118 (CN); YANG, Zeyu, Shenzhen, Guangdong 518118 (CN)
(74) Representative: Taor, Simon Edward William
(86) International application number: PCT/CN2024/079450
(87) International publication number: WO 2024/183620

(57) **Abstract**

A vehicle, having a motor controller. The motor controller has an electrical device assembly, the electrical device assembly having an electrical device. The electrical device comprises a first electrical device body, first connection terminals and second connection terminals. The first connection terminals comprise first connection parts protruding from the first electrical device body in a first direction, and the second connection terminals comprise second connection parts protruding from the first electrical device body in the first direction, each first connection part and a second connection part being stacked in a second direction intersecting the first direction, there being a plurality of first connection parts and a plurality of second connection parts, and the plurality of first connection parts and the plurality of second connection parts all being arranged at intervals.

## Description

### CROSS-REFERENCE TO RELATED APPLICATIONS

This disclosure claims priority to Chinese Patent Application No. 202310238890.9 entitled "ELECTRICAL DEVICE, ELECTRICAL DEVICE MODULE, MOTOR CONTROLLER, AND VEHICLE" filed on March 03, 2023 for Chinese Patent Office, which is incorporated herein by reference in its entirety.

### FIELD

The present disclosure relates to the technical field of electrical devices, in particular, to an electrical device, an electrical device assembly, a motor controller, and a vehicle.

### BACKGROUND

Electrical devices in an AC circuit inevitably generate stray inductance under the electromagnetic induction effect. The presence of stray inductance causes problems such as losses or signal attenuation in the circuit system, reduces the stability of the electrical device itself, and affects the function of other devices in the circuit. How to reduce the stray inductance of the electrical device becomes a problem yet to be solved in the field of electrical devices.

### SUMMARY

An object of the present disclosure is to provide an electrical device, an electrical device assembly, a motor controller, and a vehicle capable of reducing stray inductance on the electrical device, improving stability and anti-interference ability of the electrical device.

**In** order to achieve the above object, a first aspect of the present disclosure provides an electrical device comprising:
a first electrical device body;
a first connection terminal including a first connection portion protruding from the first electrical device body along a first direction;
a second connection terminal including a second connection portion protruding from the first electrical device body along the first direction, the first connection and the second connection are stacked along a second direction, the second direction intersecting the first direction;
wherein each of first connection portions and second connection portions is multiple, each of multiple first connecting portions and plurality of second connecting portions are arranged at intervals.

According to an embodiment of the present disclosure, a length of the first connection in a third direction is equal to a length of the second connection in the third direction, wherein the third direction intersects the first direction and the second direction.

According to an embodiment of the present disclosure, a length of one of the first connection portions and the second connection portion in the first direction is greater than a length of the other of the first connection portion and the second connection portion in the first direction.

According to an embodiment of the present disclosure, distance between the first connection portion and the second connection portion in the second direction is less than or equal to 1 mm.

According to an embodiment of the present disclosure, the electrical device further includes first insulating sheets, at least part of the first insulating sheets is located between the first connection portion and the second connection portion, the first insulating sheets are multiple, the multiple sheets are arranged laminated along the second direction.

A second aspect of the present disclosure provides an electrical device assembly including a first electrical device and a second electrical device, the first electrical device is electrically connected to the second electrical device, at least one of the first electrical device and the second electrical device is the electrical device described above.

According to an embodiment of the present disclosure, the first electrical device is the electrical device, the second electrical device including:
a second electrical device body;
a third connection terminal includes a third connection portion protruding from the second electrical device body along the first direction;
a fourth connection terminal includes a fourth connection portion protruding from the second electrical device body along the first direction, the third connection portion and the fourth connection portion are arranged stacked in the second direction;
the first connection portion is connected to the third connection portion, and the second connection portion is connected to the fourth connection portion.

An embodiment according to the present disclosure the third connection portion and the fourth connection portion each extend along a third direction, the multiple first connection portions and the multiple second connection portions are arranged in a one-to-one correspondence, and the multiple first connection portions and the multiple second connection portions are each arranged at intervals along the third direction, and the third connection portion is connected to the multiple first connection portions and the fourth connection portion is connected to the multiple second connecting portions, wherein the third direction intersecting both the first direction and the second direction.

An embodiment according to the present disclosure, the number of the first connection portions, the second connection portions, the third connection portions and the fourth connection portions is the same, and the multiple first connection portions are arranged at intervals along a third direction, the multiple second connection portions are arranged at intervals along the third direction, the multiple third connection portions are arranged at intervals along the third direction, and the multiple fourth connection portions are arranged along the third direction, and each first connection portion is connected to one third connection portion and each second connection portion is connected to one fourth connection portion, wherein the third direction intersects both the first direction and the second direction.

An embodiment according to the present disclosure, a length in the third direction of each of the first connection portions is the same as a length in the third direction of the third connection portion to which the first connection portion is connected, and a length in the third direction of each of the second connection portions is the same as a length in the third direction of the fourth connection portion to which the second connection portion is connected.

According to an embodiment of the present disclosure, the electrical device assembly further includes a first insulating sheet and a second insulating sheet, at least part of the second insulating sheet is located between the third connection portion and the fourth connection portion ;
a projection of at least one of the first connection portion and the second connection portion on the first insulating sheet is entirely within the first insulating sheet, and a projection of at least one of the third connection portion and the fourth connection portion on second insulating sheet is entirely within the second insulating strip .

According to an embodiment of the present disclosure, an end of the first insulating sheet away from the first electrical device body extends between the third connection portion and the fourth connection portion and laminates with the second insulating sheet in the second direction; and/or an end of the second insulating sheet away from the second electrical device body extends between the first connection portion and the second connection portion and laminates with the first insulating sheet along the second direction.

An embodiment according to the present disclosure, an end face of the first connection portion away from the first electrical device body interfaces with an end face of the third connection portion away from the second electrical device body, and an end face of the second connection portion away from the first electrical device body interfaces with an end face of the fourth connection portion away from the second electrical device body.

An embodiment according to the present disclosure, two surfaces of the first connection portion opposite along the second direction are flush with two surfaces of the third connection portion opposite along the second direction, respectively, and two surfaces of the second connection portion opposite along the second direction are flush with two surfaces of the fourth connection portion opposite along the second direction, respectively.

An embodiment according to the present disclosure, an end of the first connection portion away from the first electrical device body laps with an end of the third connection portion away from the second electrical device body, and an end of the second connection portion away from the first electrical device body laps with an end of the fourth connection portion away from the second electrical device body.

According to an embodiment of the present disclosure, lapping area of the first connection portion and the third connection portion has a length of 2 mm to 8 mm in first direction and lapping area of the second connection portion and the fourth connection portion has a length of 2 mm to 8 mm in first direction.

According to an embodiment of the present disclosure, there is a gap arranged between an end of the first connection portion away from the first electrical device body and an end of the third connection portion away from the second electrical device body, and the gap is configured to at least partially expose a connection of the second connection portion and the fourth connection portion;

the electrical device assembly further includes an intermediate connection piece, one end of the intermediate connection piece is connected with the first connection portion and other end of the intermediate connection piece is connected with the third connection portion.

In accordance with an embodiment of the present disclosure, the intermediate connection piece is located on the side of the first connection portion and the third connection portion facing away from the second connection portion and the fourth connection portion, the intermediate connection including:
a U-shaped body portion, the opening of the U-shaped body portion faces the gap, and the U-shaped body portion includes a first side wall and a second side walls disposed opposite to each other;
a first lap portion, one end of the first lap portion is connected to the first side wall and the other end is used for lapping with the first connection portion, and an inner side wall of the first side wall is flush with an end face of an end of the first connection portion away from the first electrical device body;
a second lap portion, one end of the second lap portion is connected to the second side wall and the other end is used for lapping with the third connection portion, and inner side wall of the second side wall is flush with an end face of an end of third connection portion away from second electrical device body.

A third aspect of the present disclosure provides a motor controller including the electrical device assembly described above, one of the first electrical device and the second electrical device is a capacitor and the other of the first electrical device and the second electrical device is a power device, the capacitor is for electrical connection to power battery.

A fourth aspect of the present disclosure provides a vehicle including the motor controller described above.

**In** the electrical device provided by the present disclosure, the magnetic fields excited on the first connection portion and the second connection portion are able to cancel each other out, thus, stray inductance on the electrical device is reduced, stability and anti-interference ability of the electrical device is improved, and the multiple first connection portions and the multiple second connection portions on the electrical device are arranged at intervals, which can allow current data to be collected at working conditions of the electrical device, facilitating accurate evaluation and analysis of the electrical device.

Additional features and advantages of the present disclosure will be described in detail in the following Detailed Description section.

### BRIEF DESCRIPTION OF THE DRAWINGS

The accompanying drawings are included to provide a further understanding of the disclosure and constitute a part of the specification and, together with the following detailed description, serve to explain the disclosure, but do not constitute a limitation thereof.
FIG. 1 is a perspective view of an electrical device provided according to an exemplary embodiment of the present disclosure.
FIG. 2 is a perspective view of an electrical device provided according to another exemplary embodiment of the present disclosure.
FIG. 3 is a perspective view of an electrical device assembly provided according to an exemplary embodiment of the present disclosure.
FIG. 4 is a side view of an electrical device assembly provided according to an exemplary embodiment of the present disclosure.
FIG. 5 is an enlarged view of portion "A" in FIG. 4.
FIG. 6 is a side view of an electrical device assembly provided according to another exemplary embodiment of the present disclosure.
FIG. 7 is enlarged view of section "B" in FIG. 6.
FIG. 8 is a perspective view of an electrical device assembly provided according to yet another exemplary embodiment of the present disclosure.
FIG. 9 is a side view of an electrical device assembly provided according to yet another exemplary embodiment of the present disclosure.
FIG. 10 is enlarged view of section "C" in FIG. 9.
FIG. 11 is a perspective view of an intermediate connector of an electrical device assembly provided according to yet another exemplary embodiment of the present disclosure.
FIG. 12 is a diagram of a motor controller including an electrical device assembly provided according to an exemplary embodiment of the present disclosure.
Fig. 13 is a diagram of a vehicle including a motor controller provided according to an exemplary embodiment of the present disclosure.

### DETAILED DESCRIPTION

Specific embodiments of the present disclosure are described in detail below with reference to the accompanying drawings. It is to be understood that the specific embodiments described herein are provided to illustrate and explain the present disclosure only and are not intended to limit the present disclosure.

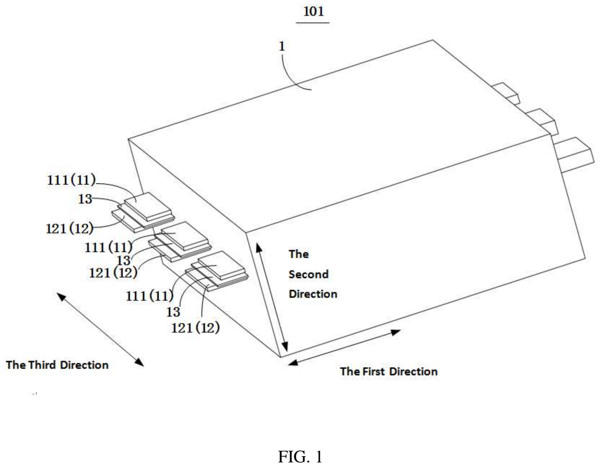

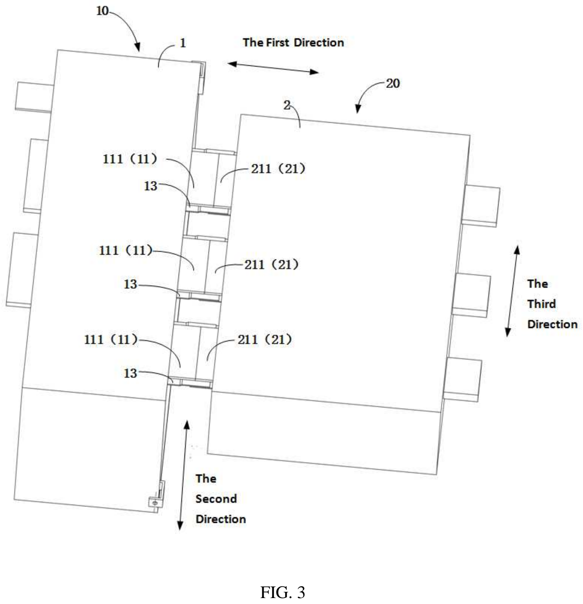

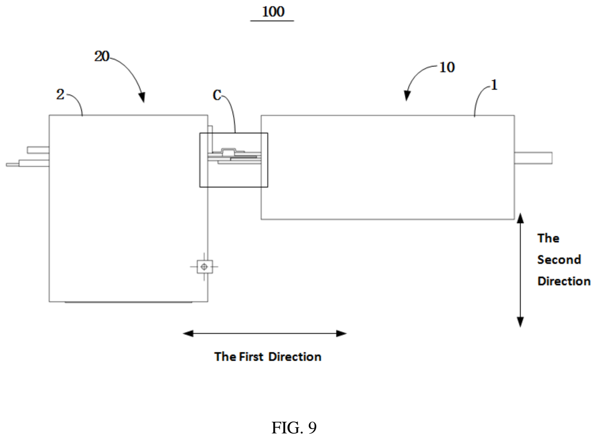

In the present disclosure, unless otherwise stated, terms such as "first direction, second direction, and third direction" are used as directions defined for convenience in describing the structure of an electrical device assembly, and are not limited to the electrical device assembly, wherein the "first direction, second direction" can be referred to the first direction, second direction indicated by arrows in FIG. 1, FIG.3, FIG.4, FIG.6 and FIG.9, and the "third direction" can be referred to the third direction indicated by the arrow in FIG. 1 and FIG. 3, and "inner, outer" may refer to the inner or outer of the contour of the relevant components. In addition, it is noted that terms such as "first," "second," and the like are used to distinguish one element from another without ordering and importance. Further, in descriptions with reference to the figures, the same reference numerals in different figures refer to the same elements.

In the related art, when an electrical device is connected to an AC circuit, since the alternating current has an electromagnetic induction effect, stray inductance can be excited in locations of connection portion , etc. of the electrical devices. For example, the electrical device may be a capacitor arranged in a motor controller of a vehicle. The capacitors in the motor controller are connected in parallel to the power device for absorbing peak tip voltages in the circuit. However, the alternating current on both sides of the capacitor can easily excite stray inductances on the connection part of the capacitor. The stray inductance will cause the voltage fluctuation to increase and cause damage to the power device, thereby affecting the safety of the vehicle.

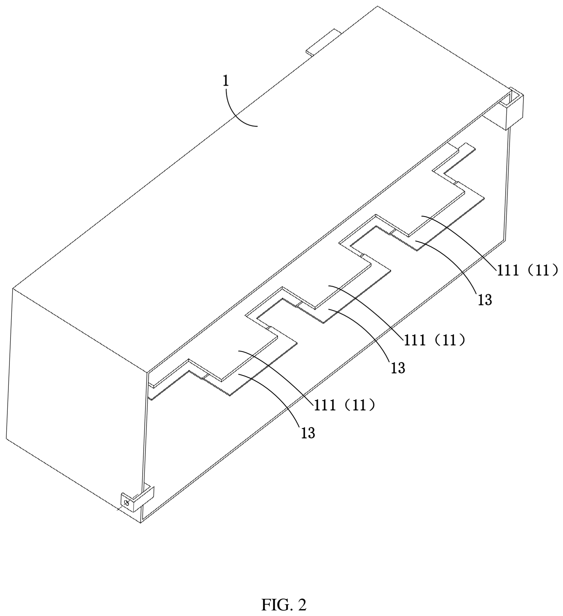

In view of this, as shown in FIG. 1 to FIG.11, a first aspect of the present disclosure provides an electrical device 101, including a first electrical device body 1, first connection terminals 11 and second connection terminals 12. The first connection terminal 11 includes a first connection portion 111 protruding from the first electrical device body 1 in the first direction, and the second connection terminal 12 includes a second connection portion 121 protruding from the first electrical device body 1 in the first direction. The first connection portions 111 and the second connection portions 121 are stacked along a second direction intersecting the first direction, wherein the first connection portions 111 and the second connection portions 121 are each multiple, and the multiple first connection portions 111 and the multiple second connection portions 121 are all arranged at intervals.

In the electrical device 101 provided by the above-described embodiment, the electrical device 101 is connected in an electrical circuit by the first connection portions 111 and the second connection portions 121, and when the electrical device 101 is connected into an AC circuit, the direction of the current on the first connection portions 111 and the second connection portions 121 keeps changing, and the direction of the current flows on the first connection portions 111 and the second connection portions 121 are always opposite. It should be noted that the direction of the current flow mentioned in the present disclosure does not refer to the direction of current flow in three-dimensional space, but refers to the circuit flow direction where the current flows in the flow path with the first electrical device body 1 as a starting point. For example, when the current on the first connection portions 111 on the electrical device 101 flows from the first electrical device body 1 to the external load device to which it is connected, the current on the second connection portions 121 flows from the external load device to the first electrical device body 1, that is, the current on the aforementioned first and second connections portions 111, 121 flows in the opposite direction.

Since direction of the current flows on the first connection portions 111 and the second connection portions 121 are always opposite, the directions of the magnetic fields excited on the first connection portions 111 and the second connection portions 121 are also opposite, as shown in FIG. 1. The first connection portions 111 and the second connection portions 121 are stacked in the second direction, and as a result, the magnetic fields excited on the first connection portions 111 and the second connection portions 121 are able to at least partially cancel each other out, thereby reducing stray inductance on the electrical device 101, improving stability and interference resistance of the electrical device 101.

In order to enable detection of the working state of an electrical device in the related art, it is generally necessary to collect current data on an electrical device. In the electrical device 101 provided by an embodiment of the present disclosure, the first connection portions 111 and the second connection portions 121 on the electrical device 101 are each multiple, and the multiple first connecting portions 111 and the multiple second connecting portions 121 are all arranged at intervals. In testing the current on the first connection portions 111 and the second connection portions 121 on the electrical device 101 described above, a clamp ammeter can be used to detect the current of the electrical device 101 in the working state. As shown in FIG. 3, since the multiple first connecting portions 111 are arranged at intervals, and a multiple second connecting portions 121 are arranged at intervals, the gap between the adjacent first connection portions 111 and second connection portions 121 in the third direction may allow the detection head of the clamp ammeter to surround the single first connection portion 111 and second connection portion 121 to collect the alternating current data on the single first connection portion 111 and the second connection portion 121. It can be seen that, the electrical device 101 may allow the electrical current on the first connection portions 111 and the second connection portions 121 to be detected when the electrical device 101 is connected to an AC circuit without the need to electrically connect other detection devices or circuits to the AC circuit, thereby reducing the impact on the AC circuit and facilitating accurate evaluation and analysis of the electrical device 101.

As an example implementation scenario, the electrical device 101 described above may be a capacitor, and the capacitor may be applied to the motor controller 200 of the vehicle 300. The first connection portions 111 and the second connection portions 121 of the capacitor may be connected to power devices within the motor controller 200. Since the magnetic field generated on the first connection portions 111 and the magnetic field generated on the second connection portions 121 can be at least partially cancel each other out, stray inductance on the capacitor can be reduced, making the "DC blocking and AC passing" function of the capacitor more stable, being able to effectively absorb the peak tip voltage in the circuit, smoothing voltage variations between the power device and the battery pack of the vehicle 300, thereby improving the stability of the vehicle power system, and ensuring the safety of the vehicle 300. Furthermore, the first connection portions 111 and the second connection portions 121 of the capacitor are each multiple, and the multiple first connecting portions 111 and the multiple second connecting portions 121 are all arranged at intervals, allowing a detection person to detect the current on the first connection portions 111 and the second connection portions 121 when the capacitor and the power device are in a connected state, and to enable respective detection of currents on a single pair of the first connection portion 111 and the second connection portion 121 and combined detection of currents across multiple pairs of first connection portions 111 and second connection portions 121, to obtain data information between multiple sets of capacitors and power devices, so as to accurately detect and evaluate the function of the motor controller 200, which is advantageous to improve the functionality and safety of the motor controller 200.

Through the above technical solution, the magnetic fields excited on the first connection portions 111 and the second connection portions 121 can at least partially cancel each other out, thus, stray inductance on the electrical device 101 is reduced, stability and anti-interference ability of the electrical device 101 is improved, and the multiple first connection portions 111 and the multiple second connection portions 121 on the electrical device 101 are arranged at intervals, which can allow current data of the electrical device 101 to be collected while in working state, facilitating accurate evaluation and analysis of the electrical device 101.

The electrical device 101 described above may be any active device or passive device. As an example of an active device, the electrical device may be an electron tube, a transistor, etc, and as an example of a passive device, the electrical device 101 may be a resistor, a capacitor, an inductor, a converter, a fader, a matching network, a resonator, a filter, or a mixer, etc. The present disclosure does not specifically limit the specific structure and function of the electrical device 101.

The first connection portions 111 and the second connection portions 121 both extend out of the housing along the first direction. Optionally, the length of the first connection portions 111 in the third direction may be equal to the length of the second connection portions 121 in the third direction, wherein the third direction intersects the first direction and the second direction. In this embodiment, the lengths of the first connection portions 111 and the second connection portions 121 in the third direction are the same, and the magnetic fields generated on the first connection portions 111 and the second connection portions 121 have a high degree of overlap, so as to cancel each other out as much as possible to minimize the stray inductance on the electrical device 101.

The smaller the distance between the first connection portions 111 and the second connection portions 121 in the second direction, the higher the overlap degree of the magnetic fields generated on the first connection portions 111 and the second connection portions 121, and the better the effect of canceling each other out. Theoretically, when the first connection portions 111 and the second connection portions 121 fully overlap, the magnetic fields on the first connection portions 111 and the second connection portions 121 can be completely cancelled out. In practical applications, in order to avoid interference of the positions of the first connection portions 111 and the second connection portions 121, optionally, the distance between the first connection portions 111 and the second connection portions 121 in the second direction may be less than or equal to 1 mm. In this embodiment, the first connection portions 111 and the second connection portions 121 can avoid position interference and realize their respective arrangements, and is possible to ensure a good effect of canceling out of the magnetic field excited on the first connection portions 111 and the second connection portions 121. Optionally, the distance between the first connection portions 111 and the second connection portions 121 in the second direction can be 0.5 mm.

To facilitate differentiation of the first connection portions 111 and the second connection portions 121, as shown in FIG. 1, FIG.5 and FIG.7, optionally, a length of one of the first connection portions 111 and the second connection portions 121 in the first direction is larger than a length of the other of the first connection portions 111 and the second connection portions 121 in the first direction. The operator is able to distinguish the relationship of the first connection portions 111 and the second connection portions 121 according to different lengths of the first connection portions 111 and the second connection portions 121 in the first direction. Thereby it is ensured that the first connection portions 111 and the second connection portions 121 can be correctly connected to an external load device. Especially in embodiments where the electrical device 101 is connected to a high-voltage circuit, when the first connection portions 111 and the second connection portions 121 of the electrical device 101 are connected to the high-voltage circuit by mistake, it is easy to cause breakdown and failure of the electrical device 101, and therefore, the first connection portions 111 and the second connection portions 121 in the above-described embodiment have different lengths in the first direction, which is conducive to distinction and recognition by an operator, so as to perform correct installation operation.

Optionally, electrical device 101 may further include a first insulating sheet 13, at least part of which are located between the first connection portion 111 and the second connection portion 121, so as to separate the current between the first connection portion 111 and the second connection portions 121, avoiding short circuit between the first connection portion 111 and the second connection portion 121.

In above-described embodiment, optionally, the first insulating sheet 13 may be multiple sheets which are laminated in second direction to be able to improve insulating performance between first connection portions 111 and second connection portions 121, avoiding occurrence of breakdown and short circuit between the first connecting portions 111 and the second connecting portions 121, and improving safety of electrical device 101.

As shown in FIGS. 3-10, a second aspect of the present disclosure provides an electrical device assembly 100 including a first electrical device 10 and a second electrical device 20, and the first electrical device 10 is electrically connected to the second electrical device 20. At least one of the first electrical device 10 and the second electrical device 20 is the electrical device 101 in the embodiments described above.

In the electrical device assembly 100 described above, the first electrical device 10 and the second electrical device 20 may be electrical devices with the same structure and function, or may be electrical devices with different structures and functions. As an exemplary embodiment, the first electrical device 10 may be a capacitor, and the second electrical device 20 may be a power device. The capacitor and the power device may each have first connection portions 11 and second connection portions 121 included in the aforementioned electrical device 101, and the first connection portions 111 and the second connection portions 121 in the capacitor are stacked in the second direction, and the first connection portions 111 and the second connection portions 121 of the power device are stacked along the second direction. As can be seen, the electrical devices included in the electrical device assembly 100 in embodiments of the present disclosure may be used to refer to electrical devices having different structures and functions, and the present disclosure is not particularly limited thereto.

As an exemplary embodiment, as shown in FIG. 3, optionally, the first electrical device 10 is the previously described electrical device 101, the electrical device assembly 100 further includes a second electrical device 20. The second electrical device 20 includes a second electrical device body 2, a third connection terminal 21 and a fourth connection terminal 22. The third connection terminal 21 include a third connection portion 211 protruding from the second electrical device body 2 along the first direction, and the fourth connection terminal 22 includes a fourth connection portion 221 protruding from the second electrical device body 2 along the first direction. The third connection portion 211 and the fourth connection portion 221 are stacked along the second direction, and the first connection portion 111 are connected to the third connection portion 211, and the second connection portion 121 are connected to the fourth connection portion 221.

In the above-described embodiment, the first electrical device 10 and the second electrical device 20 are electrically connected, and the third connection portion 211 and the fourth connection portion 221 of the second electrical device 20 are adaptable to be connected to the first connection portions 111 and the second connections 221 of the first electrical device 10. Since the third connection portion 211 and the fourth connection portion 221 are arranged stacked along the second direction, the magnetic fields excited on the third connection portion 211 and the fourth connection portion 221 are able to at least partially cancel each other out, thereby reducing stray inductance on the second electrical device 20, improving stability and anti-interference ability of the second electrical device 20. Thus, the above-described electrical device assembly 100 has good stability and anti-interference ability.

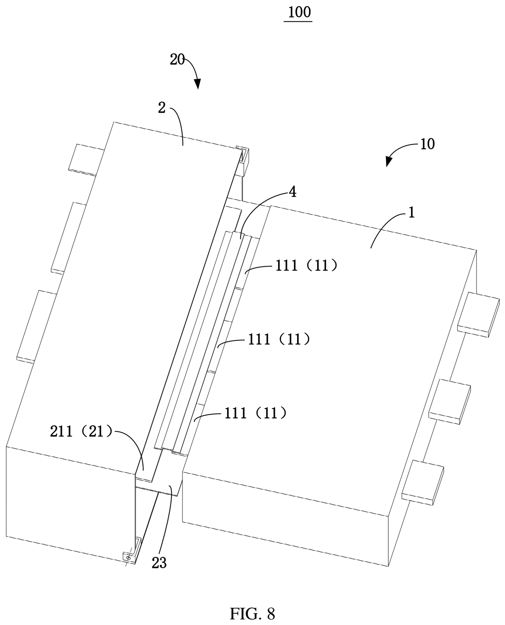

As an exemplary embodiment, as shown in FIG. 8, alternatively, the third connection portion 211 and the fourth connection portion 221 may each extend along a third direction. The multiple first connection portions 111 and the multiple second connection portions 121 are arranged in one-to-one correspondence, and the multiple first connection portions 111 and the multiple second connection portions 121 are each arranged at intervals along the third direction. The third connection portion 211 is connected with the multiple first connection portions 111, and the fourth connection portion 221 is connected with the multiple second connection portions 121, wherein the third direction intersects both the first direction and the second direction. In this embodiment, the multiple first connection portions 111 are arranged at intervals along the third direction, and the third connection portion 211 extends along the third direction, that is, the third connection portion 211 may be electrically connected to the multiple first connection portions 111 at the same time, and similarly, the fourth connection portion 221 may be electrically connected to the multiple second connection portions 121 at the same time.

As another exemplary embodiment, as shown in FIG. 3 to FIG.7, optionally, the number of the multiple first connection portions 111, the multiple second connection portions 121, the multiple third connection portions 211, and the multiple fourth connection portions 221 is the same, and the multiple first connection portions 111, the multiple second connection portions 121, the multiple third connection portions 211, and the multiple fourth connection portions 221 are all arranged at intervals along a third direction. Each first connection portion 111 is connected to a third connection portion 211, and each second connection portion 121 is connected to a fourth connection portion 221, wherein the third direction intersects both the first direction and the second direction.

In the above embodiment, as shown in FIG. 3, optionally, the length in the third direction of each first connection portion 111 is the same as the length in the third direction of the third connection portion 211 to which the first connection portion 111 is connected, so that the current flowing areas on the first connection 111 and the third connection 211 will not change suddenly, improving stability of current flow. Optionally, the length in the third direction of each second connection portion 121 may be the same as the length in the third direction of the fourth connection portion 221 to which the second connection portion 121 is connected, increasing the stability of the current flowing between the second connection portion 121 and the fourth connection portion 221. Furthermore, the lengths of the first connection portion 111 and the third connection portion 211 in the third direction are the same, so that the inductances on the first connection portion 111 and the third connection portion 211 are the same. The lengths in the third direction of the second connection portion 121 and the fourth connection portion 221 are the same, so that the inductances on the second connection portion 121 and the fourth connection portion 221 are the same, facilitating mutual cancellation of the inductances, and reducing stray inductance of the electrical device assembly 100.

Optionally, length of the first connection portion 111 in third direction, length of the second connection portion 121 in third direction, length of the third connection portion 211 in third direction, and length of the fourth connection portion 221 in third direction may all be the same, further promoting cancellation of stray inductance, and improving performance of electrical device assembly 100.

Optionally, the electrical device assembly 100 may include a first insulating sheet 13 and a second insulating sheet 23, and at least part of the second insulating sheet 23 is located between the third connection portion 211 and the fourth connection portion 221. A projection of at least one of the first connection portion 111 and the second connection portion 121 on the first insulating sheet 13 is entirely within the first insulating sheet 13, and a projection of at least one of the third connection portion 211 and the fourth connection portion 221 on the second insulating sheet 23 is entirely within the second insulating sheet 23. The electrical device assembly 100 in this embodiment ensures full insulation between the first connection portion 111 and the second connection portion 121 and full insulation between the third connection portion 211 and the fourth connection portion 221, avoiding generation of short circuits inside the electrical device assembly 100, so that the electrical device assembly 100 has good safety.

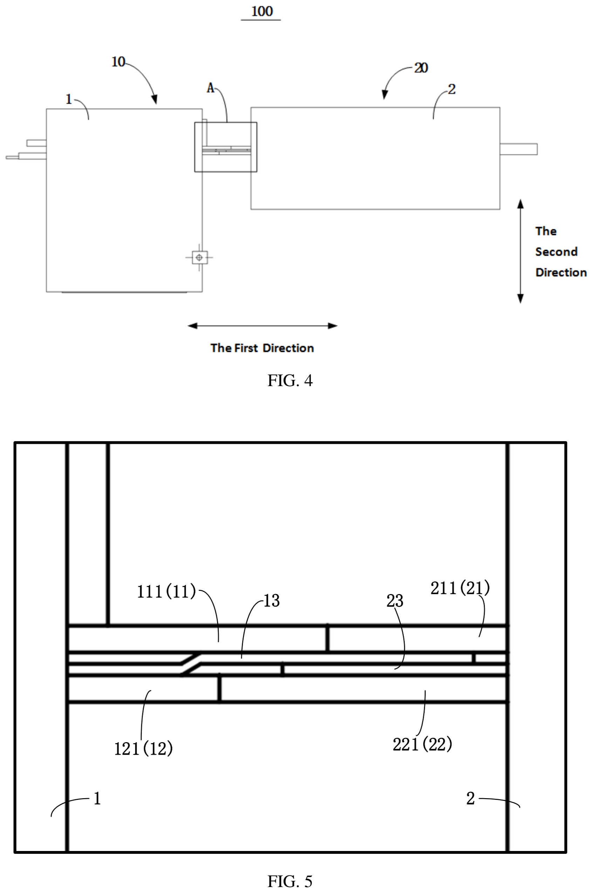

In the above embodiment, as shown in FIG. 5, FIG.7 and FIG.10, optionally, an end of the first insulating sheet 13 away from the first electrical device body 1 extends between the third connection portion 211 and the fourth connection portion 221, and the first insulating sheet 13 and the second insulating sheet 23 are laminated in the second direction. Or an end of the second insulating sheet 23 away from the second electrical device body 2 can extend between the first connection portion 111 and the second connection portion 121, and the second insulating sheet 23 the first insulating sheet 13 are laminated in the second direction. That is, the first insulating sheet 13 and the second insulating sheet 23 are laminated at least partially, thereby improving insulating performance, and avoiding breakdown by voltage.

The electrical connection between the first electrical device 10 and the second electrical device 20 may be achieved in a variety of ways. In the related art, the connection terminal of an electrical device and the connection terminal of an external load device are typically connected by a bolt. Since the bolt connection needs to occupy a certain space on the connection terminals, resulting in a problem of large size of the connection terminals. The large size of the connection terminals results in a long current path, thereby resulting in a large intensity of the magnetic field generated by the current. In order to improve the stability of the motor controller 200, optionally, the first connection portion 111 and the third connection portion 211 may be connected by a fusion welding process, and the second connection portion 121 and the fourth connection portion 221 may be connected by a fusion welding process. The fusion welding process here refers to any process such as laser welding, ultrasonic welding, or high energy particle welding, for example, the laser welding process may be used. The present disclosure is not particularly limited thereto.

Compared with the technical solutions of the related art, the electrical device assembly 100 in this embodiment, may allow to cancel screw holes on each of the first connection portion 111, the second connection portion 121, the third connection portion 211, and the fourth connection portion 221, so that the dimensions of the first connection portion 111, the second connection portion 121, the third connection portion 211, and the fourth connection portion 221 can thereby be reduced, advantageously shortening the current path between the first electrical devices 10 and second electrical devices 20, making the structure of the electrical device assembly 100 more compact, and reducing the generation of stray inductance, thereby improving the overall stability and anti-interference ability of the electrical device assembly 100.

As an exemplary embodiment, as shown in FIG. 3 to FIG. 5, optionally, an end face of the first connection portion 111 away from the first electrical device body 1 may interface with an end face of the third connection portion 211 away from the second electrical device body 2, and an end face of the second connection portion 121 away from the first electrical device body 1 interfaces with an end face of the fourth connection 221 away from the second electrical device body 2, so as to effectively improve the stability of the connection by using a face-to-face bonding connection manner. The end face of the first connection portion 111 away from the first electrical device body 1 and the end face of the third connection portion 211 away from the second electrical device body 2 need to be as flat as possible to reduce the gap between the abutting surfaces. For example, the gap between the two end surfaces may not exceed 0.2 mm to improve the stability of the connection.

In the above embodiment, optionally, two surfaces of the first connection portion 111 opposite along the second direction are flush with two surfaces of the third connection portion 211 opposite along the second direction, respectively, and two surfaces of the second connection portion 121 opposite along the second direction are flush with two surfaces of the fourth connection portion 221 opposite along the second direction, respectively, so as to be able to ensure that the current does not change suddenly during the flow process, improving the stability of the current flow, and further improving the stability of the connection.

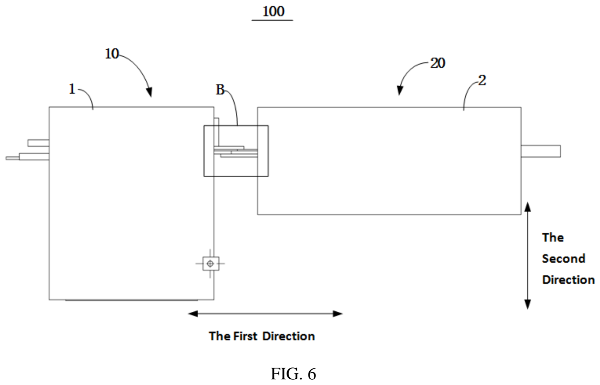

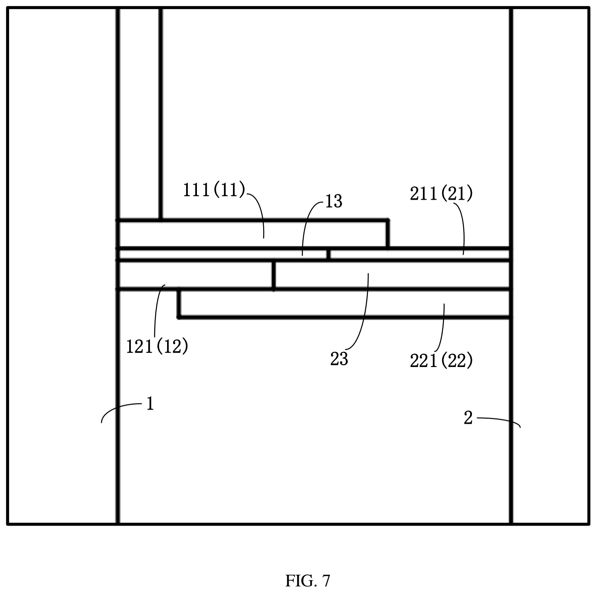

As another exemplary embodiment, as shown in FIG. 6 and FIG.7, optionally, end of the first connection portion 111 away from the first electrical device body 1 laps with end of the third connection portion 211 away from the second electrical device body 2, and end of the second connection portion 121 away from the first electrical device body 1 laps with end of the fourth connection portion 221 away from the second electrical device body 2.

For current stability, optionally, the lapping area of the first connection portion 111 and the third connection portion 211 has a length of 2 mm to 8 mm in the first direction, and the lapping area of the second connection portion 121 and the fourth connection portion 221 has a length of 2 mm to 8 mm in the first direction. In this embodiment, the current flows between the first connection portion 111 and the third connection portion 211 and the current flows between the second connection portion 121 and the fourth connection portion 221 are stable, and a working space can be reserved for the melting process between the first connection portion 111 and the third connection portion 211 and between the second connection portion 121 and the fourth connection portion 221.

As yet another exemplary embodiment, as shown in FIG. 8 to FIG. 11, optionally, there is a gap 3 between an end of the first connection portion 111 away from the first electrical device body 1 and an end of the third connection portion 211 away from the second electrical device body 2. The gap 3 is configured to at least partially expose the connection of the second connection portion 121 and the fourth connection portion 221, and the first electrical device 10 and the second electrical device 20 assembly further include an intermediate connection piece 4, one end of which is connected to the first connection portion 111 and the other end of which is connected to the third connection portion 211.

In the above embodiment, there is a gap 3 between the end of the first connection portion 111 away from the first electrical device body 1 and the end of the third connection portion 211 away from the second electrical device body 2, so that the energy source of the melting process can scan downward from the upper side of the first connection portion 111 and the third connection portion 211, and scan through the gap 3 to the connection of the second connection portion 121 and the fourth connection portion 221. After melting process of the connection of the second connection portion 121 and the fourth connection portion 221, there is no need to make large-scale adjustments or changes to the position of the electrical device assembly 100 or the energy source, melting processing between the intermediate connection piece 4 and the first connection portion 111 and the third connection portion, respectively, can be achieved. As can be seen, the embodiments described above provide an electrical device assembly 100 that is convenient to process. The melting connection between the second connection portion 121 and the fourth connection portion 221, and the melting connection between the intermediate connection piece 4 and the first connection portion 111 and the third connection portion, respectively, can be achieved without large-scale adjustments or changes to the position of the electrical device assembly 100 or the energy source, thereby simplifying the processing process and increasing the production efficiency.

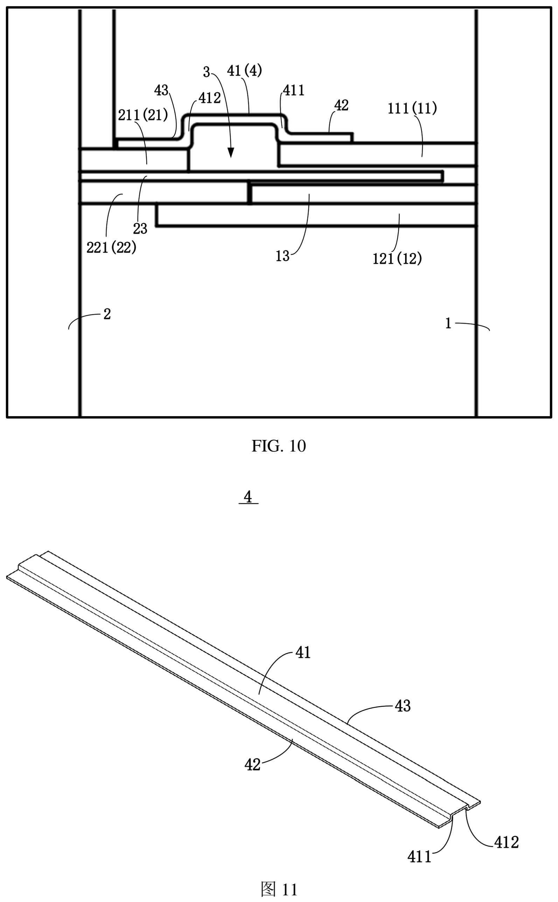

As shown in FIG. 10 and FIG. 11, optionally, the intermediate connection piece 4 may be located on a side of the first connection portion 111 and the third connection portion 211 facing away from the second connection portion 121 and the fourth connection portion 221. The intermediate connection piece 4 includes a U-shaped body portion 41, a first lap portion 42 and a second lap portion 43, wherein the opening of the U-shaped body portion 41 faces the gap 3, and the U-shaped body portion 41 includes a first side wall 411 and a second side wall 412 disposed opposite to each other. One end of the first lap portion 42 is connected to the first side wall 411, and the other end is used for lapping with the first connection portion 111, and the inner side wall of the first side wall 411 is flush with the end face of the end of the first connection portion 111 away from the first electrical device body 1. One end of the second lap portion 43 is connected to the second side wall 412 and the other end is used for lapping with the third connection portion 211, and the inner side wall of the second side wall 412 is flush with the end face of the end of the third connection portion 211 away from the second electrical device body 2.

In the above embodiment, an inner sidewall of the first side wall 411 is flush with an end face of an end of the first connection portion 111 away from the first electrical device body 1, an inner sidewall of the second side wall 412 is flush with an end face of an end of the third connection portion 211 away from the second electrical device body 2, which can facilitate the positioning of the first connection portion 111 and the first lap portion 42 and the positioning of the second lap portion 43 and the third connection portion 211 by an operator, so as to ensure that the energy source of the melting processing is able to scan the lapping area of the first connection portion 111 and the first lap portion 42 and the lapping area of the second lap portion 43 and the third connection portion 211, respectively, and the energy source is prevented from scanning to non-lapping locations causing breakdown of the first connection portion 111 or the third connection portion 211, ensuring accuracy and safety of the processing.

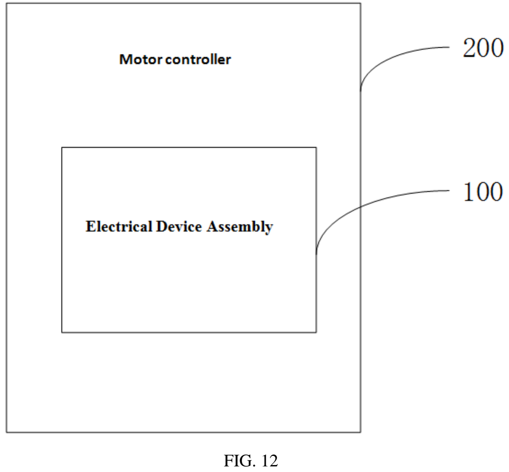

As shown in FIG. 12, a third aspect of the present disclosure provides a motor controller 200 including the electrical device assembly 100 described above, one of the first electrical devices 10 and the second electrical device 20 is a capacitor and the other of the first electrical devices 10 and second electrical device 20 is a power device, and the capacitor is for electrical connection to a power battery.

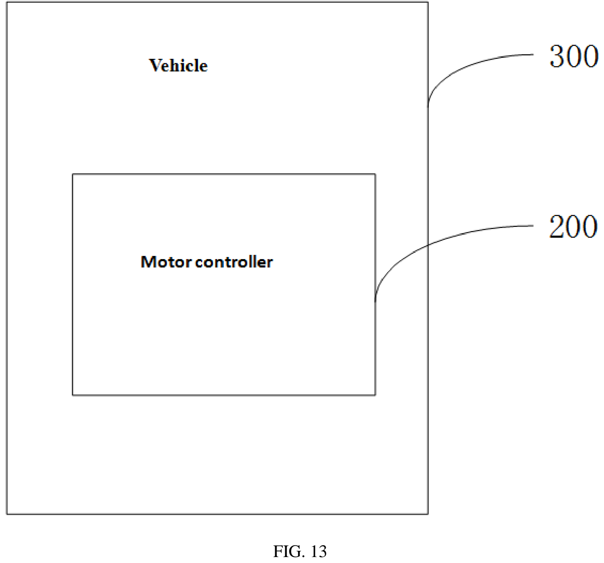

A fourth aspect of the present disclosure provides a vehicle 300, including the electrical device assembly 100 described above. As shown in FIG. 13, the vehicle 300 may include the motor controller 200 described above. The vehicle 300 herein may be an electric vehicle, a hybrid vehicle, a new energy vehicle, or the like. The present disclosure is not particularly limited thereto. Since the motor controller 200 provided by an embodiment of the present disclosure has advantages of strong anti-interference ability and high stability, it can facilitate an operator to detect the current of a capacitor or a power device, and the vehicle 300 using the above-described motor controller 200 can have good stability and safety.

Preferred embodiments of the present disclosure have been described in detail above with reference to the accompanying drawings, but the present disclosure is not limited to specific details in the above-described embodiments, and many simple modifications may be made to the technical solution of the present disclosure within the technical concept of the present disclosure, all of which are within the protection scope of the present disclosure.

Note that each of the specific technical features described in the above Detailed Description may be combined in any suitable manner without contradictin, and in order to avoid unnecessary repetition, the present disclosure is not otherwise described with respect to various possible combinations.

In addition, any combination between the various different embodiments of the present disclosure can be made, as long as it does not depart from the idea of the present disclosure, which should likewise be considered as disclosed by the present disclosure.

## Claims

1. An electrical device (101) comprising:
a first electrical device body (1);
first connection terminals (11) comprising a first connection portion (111) protruding from the first electrical device body (1) in along first direction;
second connection terminals (12) comprising a second connection portion (121) protruding from the first electrical device body (1) along the first direction, the first connection portions (111) and the second connection portions (121) being arranged in a stack along a second direction, the second direction intersecting the first direction;
wherein first connection portions (111) and second connection portions (121) being each multiple, and multiple first connection portions (111) and multiple second connection portions (121) being arranged at intervals.

2. The electrical device (101) according to claim 1, wherein a length of the first connection portions (111) in a third direction being equal to a length of the second connection portions (121) in a third direction, wherein the third direction intersecting first direction and second direction.

3. The electrical device (101) according to claim 1 or 2, wherein a length of one of the first connection portions (111) and the second connection portions (121) in the first direction being greater than a length of other of the first connection portions (111) and the second connection portions (121) in the first direction.

4. The electrical device (101) according to any one of claims 1 to 3, wherein distance between first connection (111) and second connection (121) in second direction being less than or equal to 1 mm.

5. The electrical device (101) according to any one of claims 1 to 4, wherein the electrical device (101) further comprising first insulating sheets (13), at least part of the first insulating sheets (13) being located between the first connection portion (111) and the second connection portion (121), and first insulating sheets (13) being multiple, and multiple first insulating sheets (13) being arranged laminated along the second direction.

6. An electrical device assembly (100), comprising a first electrical device (10) and a second electrical device (20), the first electrical device (10) being electrically connected to the second electrical device (20), at least one of first electrical device (10) and second electrical device (20) being electrical device (101) according to any one of claims 1 to 5.

7. The electrical device assembly (100) according to claim 6, wherein the first electrical device (10) being the electrical device (101) according to any one of claims 1 to 5, and the second electrical device (20) comprising:
a second electrical device body (2);
a third connection terminal (21) comprising a third connection portion (211) protruding from the second electrical device body (2) along the first direction;
a fourth connection terminal (22) comprising a fourth connection portion (221) protruding from the second electrical device body (2) along the first direction, and the third connection portion (211) and the fourth connection portion (221) being arranged stacked in the second direction;
the first connection portions (111) being connected to the third connection portion (211) and the second connection portions (121) being connected to the fourth connection portion (221).

8. The electrical device assembly (100) according to claim 7, wherein the third connection portion (211) and the fourth connection portion (221) each extending along a third direction, and the multiple first connection portions (111) and the multiple second connection portions (121) being arranged in a one-to-one correspondence, and the multiple first connection portions (111) and the multiple second connection portions (121) are each arranged at intervals along the third direction, and the third connection portion (211) being connected to the multiple first connection portions (111) and the fourth connection portion (221) being connected to the multiple second connecting portions (121), wherein the third direction intersecting both the first direction and the second direction.

9. The electrical device assembly (100) according to claim 7 or 8, wherein the number of the first connection portions (111), the second connection portions (121), the third connection portions (211) and the fourth connection portions (221) being the same, and the multiple first connection portions (111) being arranged at intervals along a third direction, the multiple second connection portions (121) being arranged at intervals along the third direction, the multiple third connection portions (211) being arranged at intervals along the third direction, and the multiple fourth connection portions (221) being arranged along the third direction, and each first connection portion (111) being connected to one third connection portion (211) and each second connection portion (121) being connected to one fourth connection portion (221), wherein the third direction intersects both the first direction and the second direction.

10. The electrical device assembly (100) according to claim 9, wherein a length in the third direction of each of the first connection portions (111) being the same as a length in the third direction of the third connection portion (211) to which the first connection portion (111) being connected, and a length in the third direction of each of the second connection portions (121) being the same as a length in the third direction of the fourth connection portion (221) to which the second connection portion (121) being connected.

11. The electrical device assembly (100) according to any one of claims 7 to 10, wherein the electrical device assembly (100) further comprising a first insulating sheet (13) and a second insulating sheet (23), at least part of the second insulating sheet (23) being located between the third connection portion (211) and the fourth connection portion (221);
a projection of at least one of the first connection portion (111) and the second connection portion (121) on the first insulating sheet (13) being entirely within the first insulating sheet (13), and a projection of at least one of the third connection portion (211) and the fourth connection portion (221) on second insulating sheet (23) being entirely within the second insulating strip (23).

12. The electrical device assembly (100) according to claim 11, wherein an end of the first insulating sheet (13) away from the first electrical device body (1) extending between the third connection portion (211) and the fourth connection portion (221) and laminating with the second insulating sheet (23) along the second direction; and/or an end of the second insulating sheet (23) away from the second electrical device body (2) extending between the first connection portion (111) and the second connection portion (121) and laminating with the first insulating sheet (13) along the second direction.

13. The electrical device assembly (100) according to any one of claims 7 to 12, wherein an end face of the first connection portion (111) away from the first electrical device body (1) interfacing with an end face of the third connection portion (211) away from the second electrical device body (2), and an end face of the second connection portion (121) away from the first electrical device body (1) interfacing with an end face of the fourth connection portion (221) away from the second electrical device body (2).

14. The electrical device assembly (100) according to claim 13, wherein two surfaces of the first connection portion (111) opposite along the second direction being flush with two surfaces of the third connection portion (211) opposite along the second direction, respectively, and two surfaces of the second connection portion (121) opposite along the second direction being flush with two surfaces of the fourth connection portion (221) opposite along the second direction, respectively.

15. The electrical device assembly (100) according to any one of claims 7 to 12, wherein an end of the first connection portion (111) away from the first electrical device body (1) lapping with an end of the third connection portion (211) away from the second electrical device body (2), and an end of the second connection portion (121) away from the first electrical device body (1) lapping with an end of the fourth connection portion (221) away from the second electrical device body (2).

16. The electrical device assembly (100) according to claim 15, wherein lapping area of the first connection portion (111) and the third connection portion (211) having a length of 2 mm to 8 mm in first direction and lapping area of the second connection portion (121) and the fourth connection portion (221) having a length of 2 mm to 8 mm in first direction.

17. The electrical device assembly (100) according to any one of claims 7 to 12, wherein a gap (3) being arranged between an end of the first connection portion (111) away from the first electrical device body (1) and an end of the third connection portion (211) away from the second electrical device body (2), and the gap (3) being configured to at least partially expose a connection of the second connection portion (121) and the fourth connection portion (221);
the electrical device assembly (100) further comprising an intermediate connection piece (4), one end of the intermediate connection piece (4) being connected with the first connection portion (111) and other end of the intermediate connection piece (4) being connected with the third connection portion (211).

18. The electrical device assembly (100) according to claim 17, wherein that the intermediate connection piece (4) being located on the side of the first connection portion (111) and the third connection portion (211) facing away from the second connection portion (121) and the fourth connection portion (221), the intermediate connection (4) comprising:
a U-shaped body portion (41), the opening of the U-shaped body portion (41) facing the gap (3), and the U-shaped body portion (41) comprising a first side wall (411) and a second side walls (412) disposed opposite to each other;
a first lap portion (42), one end of the first lap portion (42) being connected to the first side wall (411) and the other end being used for lapping with the first connection portion (111), and an inner side wall of the first side wall (411) being flush with an end face of an end of the first connection portion (111) away from the first electrical device body (1);
a second lap portion (43), one end of the second lap portion being connected to the second side wall (412) and the other end being used for lapping with the third connection portion (211), and inner side wall of the second side wall (412) being flush with an end face of an end of third connection portion (211) away from second electrical device body (2).

19. A motor controller (200) comprising electrical device assembly (100) according to any one of claims 6 to 18, one of the first electrical device (10) and the second electrical device (20) being a capacitor and the other of the first electrical device (10) and the second electrical device (20) being a power device, the capacitor being for electrical connection to power battery.

20. A vehicle (300) comprising motor controller (200) according to claim 19.
